# EUROPEAN PATENT APPLICATION

(11) **EP 4 525 185 A1**
(43) Date of publication of application: **19.03.2025**
(21) Application number: 24199801.2
(22) Date of filing: 11.09.2024
(51) Int. Cl.: H01M 50/48, H01M 50/50, H01M 50/51, H01M 50/56

(54) **SIGNAL COLLECTING COMPONENT AND BATTERY MODULE**

(30) Priority: 12.09.2023 CN 202322483738 U
(71) Applicant: Eve Energy Co. Ltd., Huizhou, Guangdong 516000 (CN)
(72) Inventor: Liao, Hulong, Huizhou,Guangdong, 516000 (CN)
(74) Representative: Petraz, Gilberto Luigi

(57) **Abstract**

Disclosed in the present disclosure is a signal collecting component and a battery module. The signal collecting component includes a plastic support, a busbar, a first printed circuit board, PCB, and a flexible flat cable, FFC. The busbar is configured on a side of the plastic support facing away from cells. The first PCB is configured on the plastic support, and an active front end, AFE, is integrated on the first PCB. The FFC is provided with an input port and an output port, in which the input port is connected to each busbar, and the output port is electrically connected to the AFE.

## Description

### TECHNICAL FIELD

The present disclosure relates to the technical field of batteries and, particularly, to a signal collecting component and a battery module.

### BACKGROUND

The main function of a signal collecting component is to connect the cells constituting a battery module in series and parallel, and to collect and transmit analog signals of the voltage and temperature of batteries.

In the related technology, the voltage and temperature signals collected by the signal collecting component are eventually transferred to an active front end, AFE, module in a battery management system, BMS, via cables and converted into digital signals, and the BMS then processes this digital signals. An intermediate transfer between the signal collecting component and the AFE requires dozens or hundreds of cables, and the accuracy of the transmitted temperature and voltage signals is easy to be interfered with when a distance between the signal collecting component and the AFE is too long. Also, a large number of intermediate cables is costly and have a large failure rate.

### SUMMARY

Provided in the present disclosure is a signal collecting component and a battery module for addressing the aforementioned technical issues.

As a first aspect, provided in an embodiment of the present disclosure is a signal collecting component applied to a battery module, and the battery module includes cells. The signal collecting component includes a plastic support, a busbar, a first printed circuit board, PCB, and a flexible flat cable, FFC. The busbar is configured on a side of the plastic support facing away from the cells. The first PCB is configured on the plastic support, and an active front end, AFE, is integrated on the first PCB. The FFC is provided with an input port and an output port, in which the input port is connected to each busbar, and the output port is electrically connected to the AFE.

As a second aspect, provided in an embodiment of the present disclosure is a battery module, including the aforementioned signal collecting component.

The beneficial effects of the present disclosure is as follows: in the signal collecting component provided in the present disclosure, the first PCB is integrally provided with the AFE, and a connection between the FFC and AFE is achieved through the first PCB. In such an arrangement, compared to the traditional long-distance and multi-line connection between FFC and BMS, it may effectively shorten the connection distance between the signal collecting component and AFE, thereby effectively reducing the interference in the process of transmitting signals from the FFC to the AFE, and guaranteeing the accuracy of signal transmission. Also, the AFE converts the analog signals collected through the FFC into digital signals at the signal collecting component, therefore only two intermediate cables are necessary to transfer the signals to the BMS, resulting in a small number of intermediate cables, low cost, and two cables that are easy to comb, which greatly reduces the failure rate at this position.

### BRIEF DESCRIPTION OF THE DRAWINGS

Fig. 1 is a schematic structural diagram in a perspective view of the signal collecting component provided in an embodiment of the present disclosure;
Fig. 2 is a schematic diagram in a partially enlarged view of the structure in Fig. 1 at A;
Fig. 3 is a schematic diagram in a partially enlarged view of the structure in Fig. 1 at B; and
Fig. 4 is a schematic diagram in a partially enlarged view of the structure in Fig. 1 at C.

### Description of the labels in the attached drawings:

1 plastic support; 11 extension bracket; 12 limit groove; 121 accommodating groove; 13 elastic tab; 131 snap-projection; 14 limit post; 2 busbar; 21 inspection hole; 3 first PCB; 31 first connector; 4 FFC; 41 collecting nickel sheet; 411 nickel extension part; 412 snap-fit sheet; 5 second PCB; 6 protective cover.

### DETAILED DESCRIPTION

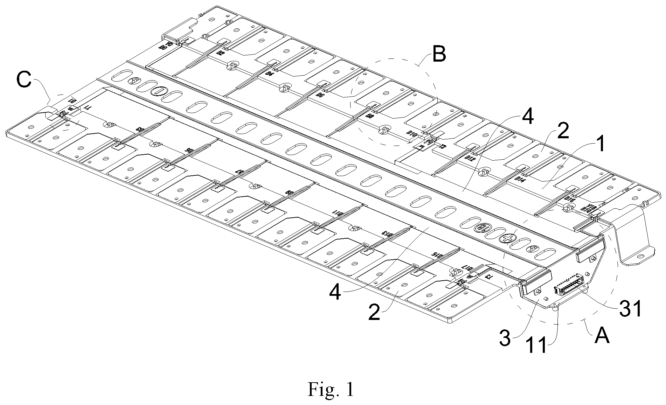

Referring to Figs. 1-4, a signal collecting component, applied to a battery module, includes a plastic support 1, a busbar 2, a first printed circuit board 3, PCB, and a flexible flat cable 4, FFC. The busbar 2 is configured on a side of the plastic support 1 facing away from cells. The first PCB 3 is configured on the plastic support, and an active front end, AFE, is integrated on the first PCB. The FFC is provided with an input port and an output port, in which the input port is connected to each busbar, and the output port is electrically connected to the AFE.

In some implementations, the input port of the FFC 4 is configured with a collecting nickel sheet 41, and the input port of the FFC 4 is connected to the busbars 2 through a collecting nickel sheet 41 for collecting voltage data of the cells. The first PCB 3 is integrally provided with the AFE, and a connection between the FFC 4 and AFE is achieved through the first PCB 3. In such an arrangement, compared to the traditional long-distance and multi-line connection between FFC 4 and BMS (not shown in figures), it may effectively shorten the connection distance between the signal collecting component and AFE, thereby effectively reducing the interference in the process of transmitting signals from the FFC 4 to the AFE, and guaranteeing the accuracy of signal transmission. Also, the AFE converts the analog signals collected through the FFC 4 into digital signals at the signal collecting component, therefore only two intermediate cables are necessary to transfer the signals to the BMS, resulting in a small number of intermediate cables, low cost, and two cables that are easy to comb, which greatly reduces the failure rate at this position.

Specifically, in some implementations, the first PCB 3 is integrally configured with a first connector 31, the connector 31 is configured to be connected to a battery management system, BMS, and the first connector 31 is electrically connected to the AFE. When in use, the BMS is configured with a second connector adapted to the first connector 31, and the first connector 31 and the second connector are in inserted connection to achieve the connection between the signal collecting component and the BMS. Optionally, the first connector 31 and the second connector are two-core connectors.

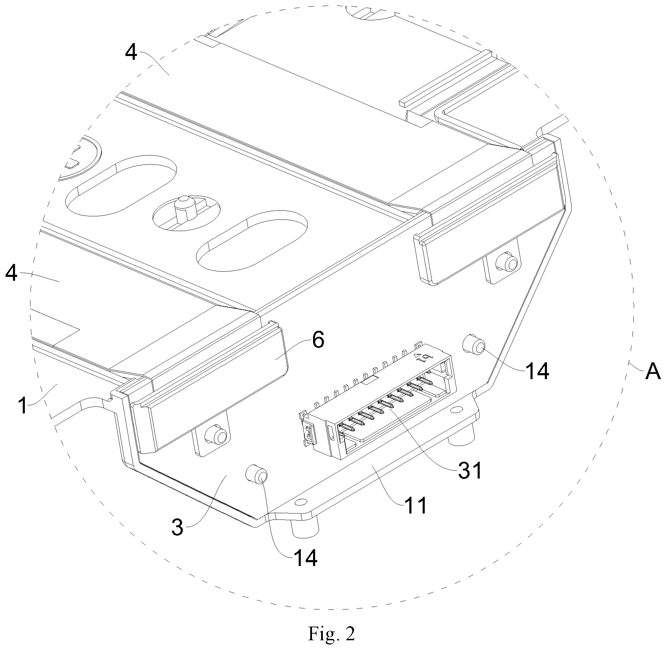

As shown in Fig. 2, the plastic support 1 is configured with an extension bracket 11, the output port of the FFC 4 is extended to the extension bracket 11, and the first PCB 3 is provided on the extension bracket 11. In some implementations, the extension bracket 11 and the plastic support 1 are integrally injection molded. By setting the first PCB 3 on the extension bracket 11, it may be avoided that the first PCB 3 affects a layout and arrangement of the busbars 2 and the FFC 4 on the plastic support 1, which is conducive to keeping the neatness of the signal collecting component.

In some implementations, the extension bracket 11 is configured with a limit post 14, the limit post 14 penetrates the first PCB 3, and the limit post 14 is configured to restrict a position of the first PCB 3. In some implementations, the limit post 14 may be a hot-riveting post. In some other implementations, the limit post 14 may be cooperated with a nut (not shown in figures), so that the nut and the limit post 14 are in a threaded connection to fixedly abut the first PCB to the extension bracket 11.

The plastic support 1 is rectangular plate in shape, and the extension bracket 11 is positioned on an end of a length direction of the plastic support 1. In some implementations, the busbar 2 is arranged along a length direction of the plastic support 1, and the FFC 4 extends along the length direction of the plastic support 1.

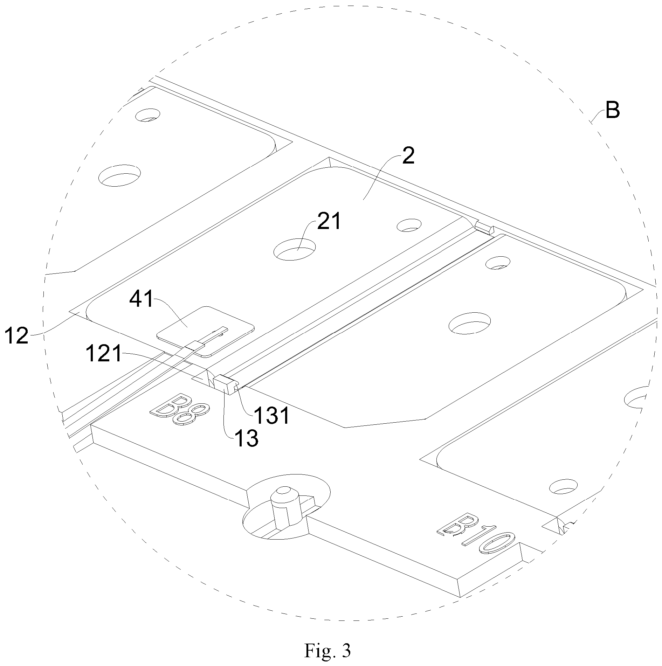

As shown in Fig. 3, the plastic support 1 is configured with a limit structure, and the limit structure is configured to restrict positions of the busbars 2. The limit structure herein is configured to fixedly restrict the busbars 2 on the plastic support 1, so as to achieve an integration of the signal collecting component.

Specifically, the limit structure includes an elastic tab 13 configured on the plastic support 1, each elastic tab 13 is configured with a snap-projection 131, and each busbar 2 is positioned between the corresponding snap-projection 131 and the plastic support 1 when each busbar 2 is assembled to the plastic support 1. The elastic tab 13 herein is integrally molded with the plastic holder 1 and has elastic deformability. When in use, when the busbar 2 is assembled to the plastic support 1 and abutted against the snap-projection 131, the elastic tab 13 is elastically deformed by a force to enable the busbar 2 to move toward the plastic support 1 until the busbar 2 is positioned between the plastic support 1 and the snap-projection 131, at which time the elastic tab 13 is reset, and the snap-projection 131 cooperates with the plastic support 1 in limiting the busbar 2. In some implementations, there may be a limit structure, which are only necessary arranged at positions for mounting the busbars.

In some implementations, the plastic support 1 is provided with a limit groove 12 adapted to each of the busbars 2, and each of the busbars 2 is embedded into the corresponding limit groove 12. The limit grooves 12 herein are configured to embed the busbars 2, which is able to lead to a reduction of an overall thickness of the signal collecting component, and also facilitate the positioning assembly between the busbars 2 and the plastic support 1.

In some implementations, at least a part of an inner wall of the limit groove 12 is abutted against the corresponding busbar 2. That is, the inner wall of the limit groove 12 is able to restrict a position of the busbar 2 when the busbar 2 is assembled into the limit groove 12, serving as a function of the aforementioned limit structure. In such an arrangement, the elastic tab 13 mentioned above may be omitted.

For facilitate description, in below implementations, a scenario in which the limit groove 12 is employed with an elastic tab 13 is taken as an example for illustration.

Specifically, as shown in Fig. 3, the inner wall of the limit groove 12 is provided with an accommodating groove 121, an elastic tab 13 is configured in the accommodating groove 121, the elastic tab 13 is configured with a snap-projection 131, and each busbar 2 is positioned between the corresponding snap-projection 131 and a bottom wall of each limit groove 12 when each busbars 2 is assembled to the limit groove 12. The accommodating groove 121 herein is capable of accommodating the elastic tab 13, thereby facilitating a reduction in a thickness of the signal collecting component. In some implementations, the busbar 2 and the inner wall of the limit groove 12 may be a tight fit or a loose fit.

As shown in Fig. 3, in some implementations, each busbar 2 is provided with an inspection hole 21and the inspection hole 21 penetrates each busbar 2. The inspection holes 21 herein facilitate inspection of the welding between the busbars 2 and the cells, such as whether there is any deficient welding between the busbars 2 and the cells.

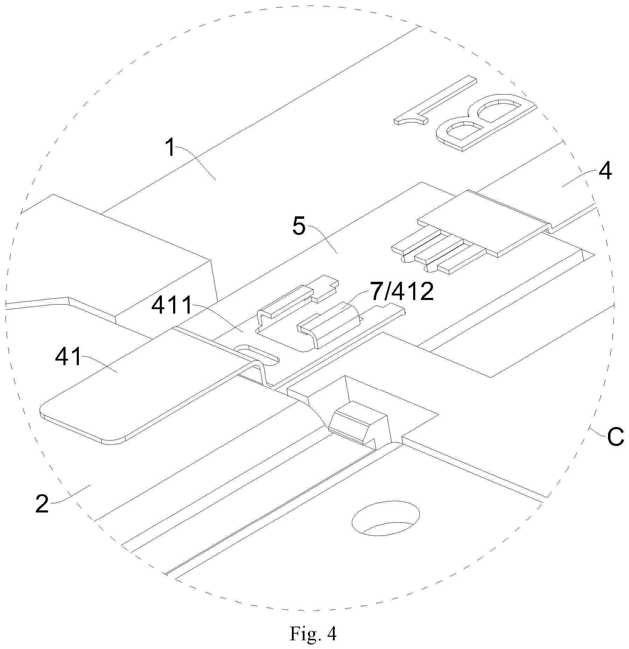

In some implementations, as shown in Figs. 1 and 4, the signal collecting component further includes a temperature sensor (not shown in figures) mounted on at least one of the busbars 2, and the temperature sensor is electrically connected to the FFC 4. The temperature sensor herein is configured to collect a temperature signal of a corresponding busbar 2, i.e., a corresponding cell.

In some implementations, the collecting nickel sheet 41 for assembling the temperature sensor is configured with a snap-fit structure 7, and the snap-fit structure 7 is configured to be in detachable connection with the temperature sensor. The snap-fit structure 7 herein facilitates the disassembly and assembly of the temperature sensor, and facilitates the maintenance of the temperature sensor in later use.

Specifically, the snap-fit structure 7 includes snap-fit sheets 412, two snap-fit sheets 412 are configured oppositely on the collecting nickel sheet 41 for assembling the temperature sensor, and a snap groove for being snap-fitted with the temperature sensor is formed between two snap-fit sheets 412. When in use, it is sufficient to insert the temperature sensor into the snap groove. Optionally, in some implementations, the snap-fit sheets 412 have elastic deformability, so that it allows the temperature sensor to be held more securely without compromising its removal efficiency.

More specifically, in some implementations, the signal collecting component further includes a second PCB 5 mounted on the plastic support 1, the second PCB corresponds to the collecting nickel sheet 41 for assembling the temperature sensor, the collecting nickel sheet 41 for assembling the temperature sensor is configured with a nickel extension part 411, the snap-fit sheets 412 are configured on the nickel extension part 411, and the temperature sensor is electrically connected to the input port of the FFC 4 through the second PCB 5. Optionally, the second PCB 5 may be connected to the plastic support 1 by a snap-fitting connection, or by a screw, or by a hot-riveting post. The assembly of the second PCB 5 and the plastic support 1 may facilitate a precise assembly of the temperature sensor and the FFC 4, and the signal transmission line between the temperature sensor and the FFC 4 is secure, which guarantees the reliability of the signal transmission between the temperature sensor and the FFC 4 during use.

As shown in Fig. 2, in some implementations, the FFC 4 is provided with a fuse (not shown in figures), and the fuse is provided close to the first PCB 3. The first PCB 3 is provided with a protective cover 6, and the fuse is positioned between the protective cover 6 and the first PCB 3. The fuse herein serves as a safety guard. Specifically, a short-circuit loop is cut off by the fuse when the signal collecting component is short-circuited due to insulation failure. The protective cover 6 is configured to protect the fuse from being damaged by external forces.

It should be noted that the protective cover 6 is made of a transparent material. Optionally, the material of the protective cover 6 includes, but is not limited to, such as transparent polycarbonate (PC) or transparent polyvinylchloride (PVC).

Provided in the present disclosure is also a battery module, including a plurality of cells and the aforementioned signal collecting component, and the plurality of cells are arranged along a length direction of the plastic support 1 and are connected in series by means of the busbars. In some implementations, the busbars 2 pass through the plastic support 1 to be connected to the cells. This battery module facilitates signal collection and is able to accurately transmitting signals to the BMS with high safety.

## Claims

1. A signal collecting component, applied to a battery module, the battery module comprising cells, the signal collecting component comprising:
a plastic support (1);
a busbar (2), configured on a side of the plastic support (1) facing away from the cells;
a first printed circuit board (3), PCB, configured on the plastic support (1), wherein an active front end, AFE, is integrated on the first PCB (3); and
a flexible flat cable (4), FFC, provided with an input port and an output port, wherein the input port is connected to each of the busbars (2), and the output port is electrically connected to the AFE.

2. The signal collecting component according to claim 1, wherein the first PCB is integrally configured with a first connector (31), the connector (31) is configured to be connected to a battery management system, BMS, and the first connector (31) is electrically connected to the AFE.

3. The signal collecting component according to claim 1, wherein the plastic support (1) is configured with an extension bracket (11), the output port of the FFC (4) is extended to the extension bracket (11), and the first PCB (3) is provided on the extension bracket (11).

4. The signal collecting component according to claim 3, wherein the extension bracket (11) is configured with a limit post (14), the limit post (14) penetrates the first PCB (3), and the limit post (14) is configured to restrict a position of the first PCB (3).

5. The signal collecting component according to claim 3, wherein the extension bracket (11) and the plastic support (1) are integrally molded.

6. The signal collecting component according to claim 1, wherein the plastic support (1) is configured with a limit structure, and the limit structure is configured to restrict positions of the busbars (2).

7. The signal collecting component according to claim 6, wherein the limit structure comprises an elastic tab (13) configured on the plastic support (1), each elastic tab (13) is configured with a snap-projection (131), and each of the busbars (2) is positioned between the corresponding snap-projection (131) and the plastic support (1) when each of the busbars (2) is assembled to the plastic support (1).

8. The signal collecting component according to claim 1, wherein the plastic support (1) is configured with a limit groove (12) adapted to each of the busbars (2), and each of the busbars (2) is embedded into the corresponding limit groove (12).

9. The signal collecting component according to claim 8, wherein at least a part of an inner wall of the limit groove (12) is abutted against the corresponding busbar (2).

10. The signal collecting component according to claim 8 or 9, wherein an inner wall of the limit groove (12) is provided with an accommodating groove (121), an elastic tab (13) is configured in the accommodating groove (121), the elastic tab (13) is configured with a snap-projection (131), and each of the busbars (2) is positioned between the corresponding snap-projection (131) and a bottom wall of each of the limit grooves (12) when each of the busbars (2) is assembled to each of the limit grooves (12).

11. The signal collecting component according to claim 1, wherein an inspection hole (21) provided penetrating each of the busbars (2).

12. The signal collecting component according to claim 1, further comprising a temperature sensor mounted to at least one of the busbars (2), and the temperature sensor is electrically connected to the FFC (4).

13. The signal collecting component according to claim 12, wherein the FFC (4) is connected to the busbars (2) through a collecting nickel sheet (41), the collecting nickel sheet (41) for assembling the temperature sensor is configured with a snap-fit structure (7), and the snap-fit structure (7) is configured to be in detachable connection with the temperature sensor.

14. The signal collecting component according to claim 13, wherein the snap-fit structure (7) comprises snap-fit sheets (412), two snap-fit sheets (412) are configured oppositely on the collecting nickel sheet (41) for assembling the temperature sensor, a snap groove is formed between two snap-fit sheets (412), and the snap groove is configured to be snap-fitted with the temperature sensor.

15. The signal collecting component according to claim 14, further comprising a second PCB (5) mounted on the plastic support (1), the second PCB corresponds to the collecting nickel sheet (41) for assembling the temperature sensor,
the collecting nickel sheet (41) for assembling the temperature sensor is configured with a nickel extension part (411), the snap-fit sheets (412) are configured on the nickel extension part (411), and
the temperature sensor is electrically connected to the input port of the FFC (4) through the second PCB (5).

16. The signal collecting component according to claim 1, wherein the FFC (4) is configured with a fuse.

17. The signal collecting component according to claim 16, wherein the fuse is closed to the first PCB (3),
the first PCB (3) is configured with a protective cover (6), and the fuse is positioned between the protective cover (6) and the first PCB (3).

18. The signal collecting component according to claim 17, wherein the protective cover (6) is made of a transparent material.

19. A battery module, comprising the signal collecting component according to any one of claims 1-18.

20. The battery module according to claim 19, wherein the battery module comprises a plurality of cells, the plurality of cells are arranged along a length direction of the plastic support (1),
and the busbars (2) pass through the plastic support (1) to be connected to the plurality of cells, so that the plurality of cells are connected in series.
